**Europäisches Patentamt**

**European Patent Office**

**Office européen des brevets**

(19)

(11) Veröffentlichungsnummer: **0 246 489**
A2

## (12) EUROPÄISCHE PATENTANMELDUNG

(21) Anmeldenummer: **87106518.1**

(22) Anmeldetag: **06.05.87**

(51) Int. Cl.4: **H05K 3/34** , H01R 4/02

(30) Priorität: **20.05.86 DE 3616897**

(43) Veröffentlichungstag der Anmeldung:
**25.11.87 Patentblatt 87/48**

(84) Benannte Vertragsstaaten:
**AT BE CH ES FR GB IT LI NL SE**

(71) Anmelder: **Raible, Fritz**
**Panorama Strasse 38**
**D-7247 Sulz a.N.-Bergfelden(DE)**

(72) Erfinder: **Raible, Fritz**
**Panorama Strasse 38**
**D-7247 Sulz a.N.-Bergfelden(DE)**

(74) Vertreter: **Neymeyer, Franz, Dipl.-Ing. (FH)**
**Haselweg 20**
**D-7730 Villingen 24(DE)**

(54) **Lötanschlussvorrichtung für elektrische und/oder elektronische Bauteile.**

(57) Um zu erreichen, daß mit Lötstiften versehene elektrische oder elektronische Bauteile (1) durch flach aufeinanderliegende Berührungsflächen mit den dafür vorgesehenen Leiterbahnen (20, 21, 22, 23) einer Leiterplatte (19) kontaktierend verbunden werden können, ohne daß dazu die Leiterplatte (19) zur Aufnahme der Lötstifte mit Löchern versehen sein muß, ist eine Lötanschlußvorrichtung vorgesehen, bei der die einzelnen Lötstifte (9, 10) jeweils mit in oder an einer gemeinsamen Sockelplatte (12) aus Isolierstoff befestigten Kontaktfüßen (13) elektrisch leitend verbunden sind. Die Kontaktfüße (13) weisen jeweils Lötkontaktflächen auf, die in einer gemeinsamen Ebene liegen. Die Lötstifte (9, 10) sind in ihrer Länge so gestaltet daß sie in oder vor den Lötkontaktflächen innerhalb der Kontaktfüße (13) enden. Dadurch ist es möglich, elektrische oder elektronische Bauteile, bei denen Lötstifte als Verbindungselemente unentbehrlich sind, nach der verfahrenstechnisch vorteilhafteren SMD-Methode auf Leiterbahnen kontaktierend zu befestigen.

Fig. 1

## Lötanschlußvorrichtung für elektrische und/oder elektronische Bauteile.

Die Erfindung betrifft eine Lötanschlußvorrichtung für elektrische und/oder elektronische Bauteile, die mit wenigstens zwei auf der Unterseite oder Oberseite hervorstehenden, zueinander parallelen Lötstiften versehen sind.

Zur Anordnung und Befestigung von elektrischen oder elektronischen Bauteilen, wie z.B. integrierter Bausteine, Induktivitäten, Kleintrafos u.dgl., auf sog. gedruckten Leiterplatten sind die Bauteile häufig mit vorstehenden Löstiften versehen, die vorwiegend auf automatisch arbeitenden Bestückungsmaschinen in entsprechende Bohrungen der Leiterplatte eingesteckt und dort anschließend mit den diese Bohrungen umschließenden Leiterbahnabschnitten verlötet werden. Neuere Befestigungsmethoden (SMD-Technik), die insbesondere für miniaturisierte Bauteile und für eine andere Löttechnik entwickelt worden sind, sehen jedoch vor, die Bauteile, soweit möglich, mit flachen Kontaktelementen zu versehen, die flächig auf die zu kontaktierenden Leiterbahnen klebend aufgelegt werden und durch ein besonderes Lötverfahren auf den Leiterbahnen festgelötet werden. Derartige Bauteile weisen normalerweise keine oder abgewinkelte Lötstifte auf. Die flachen Kontaktelemente sind in der Regel an einem Gehäuseteil oder Trägerteil aus Kunststoff, Keramik oder Ferrit in einer Ebene angeordnet und befestigt und beispielsweise mit angelöteten Drahtenden verbunden.

Bei manchen elektrischen oder elektronischen Bauteilen, z.B. bei kleinen Spulen, Trafos, od. dgl., sind aber die Lötstifte aus fertigungstechnischen Gründen unverzichtbar, zumal dann, wenn diese mit relativ dicken Drähten gewickelt sind, deren Enden beim Wickeln auf Wickelautomaten an solchen Lötstiften durch Umwickeln befestigt werden müssen, um nicht verloren zu gehen und wenn die elektronischen Bauteile in Schutzgehäuse eingegossen sind, um die nötige Stabilität und Widerstandsfähigkeit gegen äußere Einflüße zu erhalten.

Der Erfindung liegt die Aufgabe zugrunde, eine Lötanschlußvorrichtung der eingangs genannten Art zu schaffen, durch welche es möglich ist, die mit Lötstiften versehenen Bauteile durch flach aufeinanderliegende Berührungsflächen mit den dafür vorgesehenen Leiterbahnen einer Leiterplatte kontaktierend zu verbinden ohne daß dazu in der Leiterplatte Löcher zur Aufnahme der Lötstifte erforderlich sind.

Gelöst wird diese Aufgabe erfindungsgemäß dadurch, daß die einzelnen Lötstifte jeweils mit in oder an einer gemeinsamen Sockelplatte oder in einer Gehäusewand (33) aus Isolierstoff befestigten Kontakfüßen elektrisch leitend verbunden sind, welche jeweils in einer gemeinsamen Ebene liegende Lötkontakflächen aufweisen, in oder vor welchen die Lötstifte enden. Durch diese erfindungsgemäße Naßnahme ist es möglich, die bisher in der Regel auf automatischen Maschinen hergestellten elektrischen oder elektronischen Bauteile, z.B. Tafo-Spulen, Drossel-Spulen od. dgl., deren Wicklungsenden leitend mit den Lötstiften verbunden sind, in gleicher Weise herzustellen, wie bisher, trotzdem aber den Vorteil zu haben, sie auf Leiterbahnen nach der vorteilhafteren, sog. SMD-Methode (S = surface = Oberfläche, M = mounted = montiert, D = device = Einrichtung) befestigen zu können, nach welcher die Kontakfüße mit ihren Leitkontakflächen flach auf die mit ihnen zu verbindenden Leiterbahnen aufgesetzt, mittels eines gleichzeitig als Haftmittel dienenden Flußmittels auf den Leiterbahnen vorläufig angeklebt und durch einen anschließenden Lötvorgang stoffschlüssig und elektrisch leitend mit den Leiterbahnen verbunden werden.

Je nach Art des Bauteils kann es vorteilhaft sein, die Kontaktfüße gemäß Anspruch 2, 3 oder 4 zu gestalten. In allen Fällen ist es möglich, die Kontaktfüße automatisch an bzw. auf den Sockelplatten anzubringen und zu befestigen, um sie dann gemeinsam auf die Kontaktstifte aufzusetzen und mit diesen zu verlöten. Es versteht sich, daß die Länge der einzelnen Kontaktstifte so bemessen sein muß, daß diese nicht in die Ebene der Lötkontaktflächen der einzelnen Kontaktfüße hineinragen.

Durch die Ausgestalung gemäß Anspruch 5 ergibt sich der zusätzliche Vorteil, daß das elektrische oder elektronische Bauteil vollständig in einem geschlossenen Gehäuse verkapselt und somit insbesondere auf dem Weg von Herstellungsort zum Verarbeitungsort gegen schädliche äußere Einflüße geschützt ist.

Die Erfindung wird im folgenden anhand der Zeichnung näher erläutert. Es zeigt:

Fig. 1 Eine Lötanschlußvorrichtung der erfindungsgemßen Art in Explosionsdarstellung;

Fig. 2 einen Teilschnitt durch eine Sockelplatte mit zwei eingesetzten flanschhülsenartigen Kontakfüßen;

Fig. 3 die Schnittdarstellung eine hülsenartigen Kontaktfußes, der auf einer Leiterbahn einer Leiterplatte aufsitzt;

Fig. 4 einen Schnitt durch ein elektronisches Bauteil mit der erfindungsgemäßen Lötanschlußvorrichtung;

Fig. 5 eine mit andersartig ausgebildeten Kontaktfüßen versehene Sockelplatte in perspektivischer Draufsicht;

Fig. 6 einen Teilschnitt VI-VI aus Fig. 5;

Fig. 7 ein in ein Gehäuse eingegossenes elektronisches Bauteil im Schnitt.

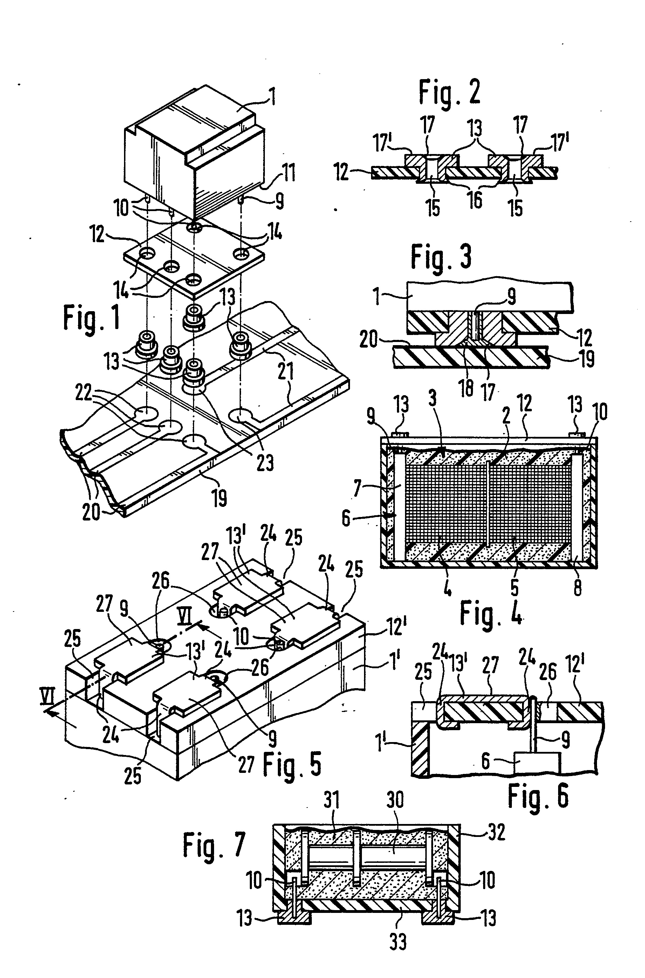

In Fig. 4 der Zeichnung ist als elektronisches Bauteil ein in einem würfelförmigen Gehäuse 1 mittels Gießharz 2 eingegossener Kleintrafo 3 mit zwei Spulen 4 und 5 und einem Spulenkörper 6 dargestellt. In den jeweils stirnseitig angeordneten Wandelementen 7 und 8 des Spulenkörpers 6 sind Lötstifte 9 bzw. 10 derart angeordnet, daß sie zunächst 2 mm bis 3 mm parallel zueinander verlaufend aus der offenen Seite 11 des Gehäuses 1 herausragen, wie das in Fig. 1 dargestellt ist. Um diese aus der offenen Gehäuseseite 11 herausragenden Endabschnitte der Lötstifte 9 und 10 in einer aus elektrisch nicht leitendem Material bestehenden Sockelplatte 12 befestigen zu können, sind in dieser metallene Kontaktfüße 13 in Form von Flanschhülsen angeordnet. Diese Flanschhülsen 13 sitzen in Bohrungen 14 der Sockelplatte 12 und sind jeweils mit zentralen Bohrungen 15 versehen, in welche die Endabschnitte der Lötstifte 9 und 10 hineinragen. Es versteht sich, daß die Anordnung der Bohrungen 14 und somit der Kontaktfüße 13 so getroffen ist, daß beim Auflegen der Kontaktplatte 12 auf die offene Gehäuseseite 11 des Gehäuses 1 jeweils ein Kontaktfuß 13 das Ende eines Lötstiftes 9 bzw. 10 aufnimmt. Durch Verlöten werden dann die Lötstifte 9 und 10 mit den Kontaktfüßen mechanisch fest und elekrisch leitend verbunden, so daß die offene Gehüuseseites 11 des Gehäuses 1 durch die Sockelplatte 12 verschlossen ist. Aus Fig. 2 ist erkennbar, daß die flanschhülsenartigen Kontaktfüße 13 durch einen umgebördelten Randabschnitt 16 festsitzend in der Sockelplatte 12 befestigt sind.

Um das Verlöten der Kontaktstifte 9, 10 mit dem Kontaktfüßen 13 zu erleichtern, sind letzere auf der nach außen gerichteten Stirnseite, welche später die Lötkontaktfläche 17' bildet, jeweils mit konischen Vertiefungen 17 versehen, welche nach dem Löten zumindest teilweise mit Lötmittel 18 aufgefüllt ist, wie es Fig. 3 zeigt. In den Fig. 2 und 4 sind die Teile jeweils in der Position dargestellt, in welcher sie zusammengefügt werden. In Fig. 1 und 3 sind die Teile in der Lage dargestellt, in welcher sie auf die Oberseite eine Leiterplatte 19 bzw. auf deren Leiterbahnen 20 bzw. 21 aufgesetzt werden. Zur Aufnahme der Kontakfüße 13 sind die Enden der Leiterbahnen 20 und 21 jeweils mit erweiterten Kreisflächen 22 bzw. 23 versehen, damit ein größerer Flächenkontakt erreicht werden kann. Um zu erreichen, daß die Kontakfüße 13 schon vor dem späteren Lötvorgang auf den Kreisflächen 22, 23 der Leiterbahnen 20 bzw. 21 eine gute Haftung erhalten und sich nach dem Aufsetzen nicht mehr selbsttätig verschieben, werden ihre Stirnflächen 17' mit einem Lötmittel bestrichen, das zugleich Klebereigenschaften besitzt und bei späterer Erwärmung die Lötverbindung zwischen den Kontaktfüßen und den Kresiflächen 22 und 23 der Leiterbahnen 20 bzw. 21 erzeugt.

Beim Ausführungsbeispiel der Fig. 5 und 6 ist für das in einem Gehäuse 1' untergebrachte elektronische Bauteil eine Sockelplatte 12' vorgesehen, welche mit vier plattenartigen Kontakfüßen 13' versehen ist. Diese plattenartigen Kontaktfüße 13' weisen jeweils eine rechteckige Lötkontaktfläche 27 auf und sind jeweils auf sich gegenüberliegenden Seiten mit Krallfingern 24 versehen, die durch Schlitzöffnungen 25 bzw. Durchbrüche 26 der Sockelplatte 12' hindruchragen und auf der Unterseite klammerartig umgebogen sind. Es ist aus den Fig. 5 und 6 ohne weiteres erkennbar, daß die mit den Kontaktfüßen 13' zu verbindenden Lötstifte 9 bzw. 10 jeweils nahe eines Krallfingers 24 in einen der Durchbrüche 26 ragen und an den Krallfingern festgelötet oder festgeschweißt sind.

Bei beiden Ausführungsformen ist wesentlich, daß die stirnseitigen Kontaktflächen 17' bzw. 27' der Kontaktfüße 13 bzw. 13' in einer gemeinsamen ebene liegen, was im wesentlichen dadurch erreicht wird, daß die Kontaktfüße jeweils festsitzend auf derselben Flachseite der an sich ebenen Sockelplatte 12 bzw. 12' angeordnet sind.

Es sind auch andere, z.B. hohlnietenartige Formen von Kontaktfüßen und auch andere Befestigungsarten von Kontaktfüßen denkbar, wobei jedoch in jedem Fall zu beachten ist, daß sowohl zur Anbringung der Kontaktfüße an der Sockelplatte als auch zur Herstellung der elektrisch leitenden und mechanisch festen Verbindung zwischen den Lötstiften 9 bzw. 10 und den einzelnen Kontaktfüßen möglichst automatisierte Arbeitsgänge anwendbar sein sollen.

Ebenso ist es auch ohne weiteres möglich die erfindungsgemäße Vorrichtung bei offenen d.h. nicht verkapselten elektronsichen oder elektrischen Bauteilen, z.B. bei Einfach-oder Mehrfach-Spulen anzuwenden, die kein Schutzgehäuse aufweisen. Durch die Sockelplatte 12 bzw. 12' erhält das Bauteil eine erhöhte mechansiche Stabilität.

Beim Ausführungsbeispiel der Fig. 7 ist ein nur andeutungsweise in Form eines Spulenkörpers 30 dargestelltes elektronisches Bauteil mittels Gießharz 21 in ein Kunststoffgehäuse 32 eingegossen. In der Bodenwand 33 sind wie in der Sockelplatte 12 beim Ausführungsbeispiel der Fig. 1 Kontaktfüße 13 befestigt, die mit den Lötstiften 10 des elektronsichen Bauteils in der vorbeschriebenen Weise verlötet sind.

## Ansprüche

1. Lötanschlußvorrichtung für elektrische und/oder elektronische Bauteile, die mit wenigstens zwei auf der Unterseite oder Oberseite hervorstehenden, zueinander prallelen Lötstiften versehen sind,

**dadurch gekennzeichnet,**

daß die einzelnen Lötstifte (9, 10) mit in oder an einer gemeinsamen Sockelplatte (12, 12') oder an einer Gehäusewand (23) aus Isolierstoff befestigten Kontaktfüßen (13, 13') elektrisch leitend verbunden sind, welche jeweils in einer gemeinsamen Ebene leigende Lötkontaktflächen (17' 27) aufweisen, in oder vor welchen die Lötstifte (9, 10) enden.

2. Vorrichtung nach Anspruch 1, dadurch gekennzeichnet, daß die Kontaktfüße (13) aus metallenen Flanschhülsen oder Hohlnieten bestehen, die in Bohrungen (14) der Sockelplatte (12) befestigt sind.

3. Vorrichtung nach Anspruch 1, dadurch gekennzeichnet, daß die Kontaktfüße (13') aus platten- oder zungenartigen Flachmetallteilen bestehen, welche festsitzend and der Sockelplatte (12') befestigt sind und mit den Lötstiften (9, 10) verlötet, verklemmt oder veschweißt sind.

4. Vorrichtung nach Anspruch 3, dadurch gekennzeichnet, daß die Flachmetallteile (13') mittels einstückig angeformten Krallfinger (24) in schlitzförmigen Öffnungen (25) und/oder Durchbrüchen (26) der Sockelplatte (12') befestigt sind, wobei jeweils an einem der Krallfinger (24) ein Lötstift (9, 10) angelötet oder angeschweißt ist.

5. Vorrichtung nach einem der Ansprüche 1 bis 3, dadurch gekennzeichnet, daß die Sockelplatte (12, 12') den Boden oder Deckel eines Gehäuses (1) bildet, in welche das zu kontaktierende elektrische oder elektronische Bauteil eingesetzt, insbesondere mittels Gießharz (2) eingegossen wird.

Fig. 2

Fig. 3

Fig. 1

Fig. 4

Fig. 5

Fig. 6

Fig. 7